(19) Europäisches Patentamt / European Patent Office / Office européen des brevets

(11) **EP 4 761 279 A1**

(12) **DEMANDE DE BREVET EUROPEEN**

(43) Date de publication:
**17.06.2026 Bulletin 2026/25**

(21) Numéro de dépôt: **25223067.7**

(22) Date de dépôt: **12.12.2025**

(51) Classification Internationale des Brevets (IPC):
**H04R 1/34** (2006.01)      **H04R 1/02** (2006.01)
**H04R 1/30** (2006.01)

(52) Classification Coopérative des Brevets (CPC):
**H04R 1/345;** H04R 1/023; H04R 1/028; H04R 1/30

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**
Etats d'extension désignés:
**BA**
Etats de validation désignés:
**GE KH LA MA MD TN**

(30) Priorité: **16.12.2024 FR 2414257**

(71) Demandeur: **SAGEMCOM BROADBAND SAS 92270 Bois-Colombes (FR)**

(72) Inventeurs:
• **MARTIN DE MONTAUDRY, Charles-Efflam 92270 BOIS-COLOMBES (FR)**
• **BOURGOIN, Gilles 92270 BOIS-COLOMBES (FR)**

(74) Mandataire: **Cabinet Boettcher 5, rue de Vienne 75008 Paris (FR)**

(54) **BLINDAGE DÉFLECTEUR ACOUSTIQUE**

(57) Equipement audio (20) comportant :
- un circuit imprimé (23) sur lequel est monté au moins un composant électronique (24) ;
- un haut-parleur (27)
- un capot de blindage (31) agencé pour protéger le composant électronique, le capot de blindage comportant une face externe (32) positionnée en regard de la membrane (43) du haut-parleur (27) ;
la face externe (32) comprenant au moins une surface courbe (37) qui s'étend depuis une partie centrale (38) de la face externe (32) vers un contour (39) de la face externe, le capot de blindage (31) étant ainsi agencé pour diffracter des ondes acoustiques produites par la membrane du haut-parleur en fonctionnement de manière à réduire des vibrations indésirables du circuit imprimé (23) et du capot de blindage.

Fig. 6

**Description**

L'invention concerne le domaine des équipements audio intégrant à la fois un ou des composants électroniques nécessitant un blindage électromagnétique, et un ou des haut-parleurs.

ARRIERE-PLAN DE L'INVENTION

Certains équipements intègrent à la fois des composants électroniques permettant de mettre en œuvre des fonctions complexes, et un dispositif audio comprenant un ou des haut-parleurs.

C'est par exemple le cas de certains boîtiers décodeurs (ou STB, pour *Set-Top Box*) qui intègrent des haut-parleurs et qui, en plus de réaliser leurs fonctions « classiques » (acquisition d'un flux audio-vidéo, décodage, diffusion du flux, etc.), restituent au moins partiellement le flux audio.

Un tel boîtier décodeur « avancé » comprend des composants électroniques de traitement qui doivent être protégés contre les perturbations électromagnétiques et qui nécessitent donc un blindage électromagnétique. Or, ce type d'équipement est relativement compact et l'intégration des composants électroniques, des dispositifs de blindages et des haut-parleurs s'avère relativement compliquée.

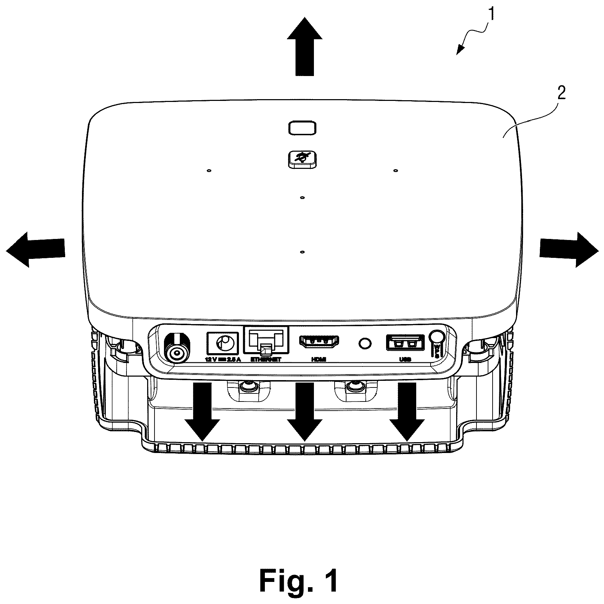

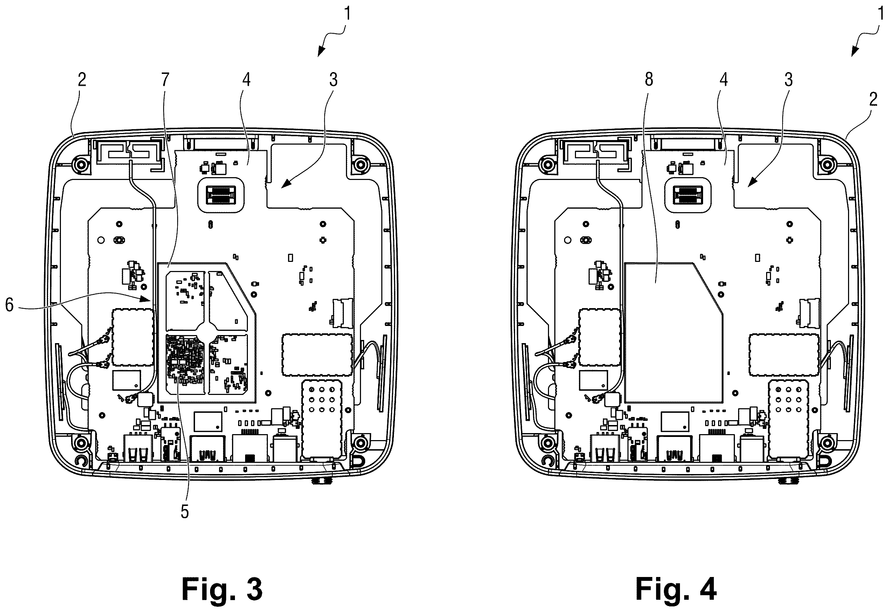

Un tel boîtier décodeur 1 est représenté sur les figures 1 à 4.

L'enveloppe externe du boîtier décodeur 1 comporte un capot supérieur 2 définissant une face supérieure du boîtier décodeur 1. Le boîtier décodeur 1 comporte une carte électronique 3, ici la carte-mère, qui comprend un circuit imprimé 4 sur lequel sont montés des composants électroniques. Le circuit imprimé 4 est fixé au capot supérieur 2 par vissage au niveau de ses quatre coins. Parmi les composants électroniques, on trouve des composants électroniques 5 qui sont protégés par un dispositif de blindage électromagnétique 6.

Le dispositif de blindage 6 est formé par exemple d'une ceinture de blindage 7 montée sur la carte électronique 3, et d'un capot de blindage 8 inséré en force autour de la ceinture 7. Ces éléments de blindage sont par exemple réalisés en tôle pliée sur tout le pourtour, embossée et découpée, de 0,2 mm d'épaisseur.

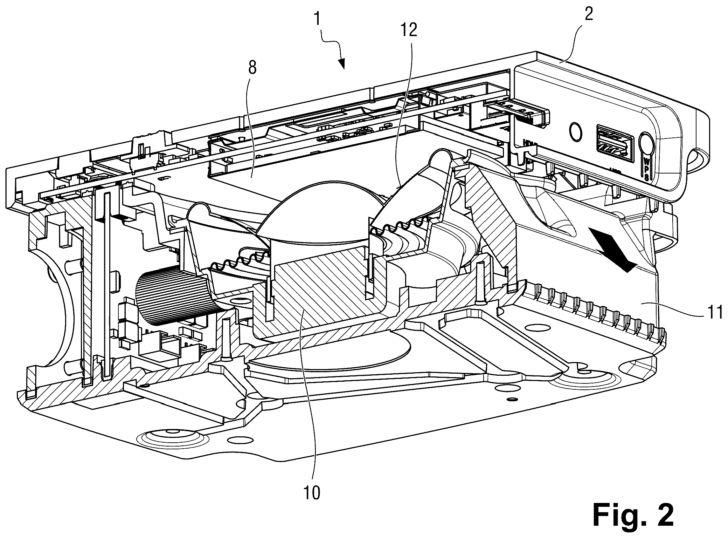

Le boîtier décodeur 1 comprend aussi un haut-parleur 10 intégré dans un caisson acoustique 11 lui-même intégré dans le boîtier décodeur 1. Ce haut-parleur 10 est ici un haut-parleur de graves (*woofer*) qui, du fait de l'espace disponible très réduit, est situé à proximité du dispositif de blindage 6. Le capot de blindage 8 comprend une face externe de forme plane située en regard et très proche de la membrane 12 du haut-parleur 10, et donc parallèle à l'onde sonore générée par le haut-parleur 10. L'air s'échappe ensuite principalement par les côtés et par l'arrière du boîtier décodeur 1, comme indiqué par les flèches sur les figures 1 et 2.

Cette configuration pose les problèmes suivants.

L'énergie générée par le déplacement de la membrane 12 du haut-parleur 10 produit des vibrations indésirables du sous-ensemble comprenant la carte électronique 3 et le capot de blindage 8. De plus, comme le capot de blindage 8 est situé juste au-dessus du haut-parleur 10, celui-ci peut également vibrer de manière indépendante contre la ceinture de blindage 7.

Par ailleurs, l'architecture mécanique du boîtier décodeur 1 engendre la présence d'une cavité autour du haut-parleur 10 avec de nombreux plans parallèles entre le caisson acoustique 11 et le capot supérieur 2. Cette configuration particulière génère donc un phénomène de résonance acoustique et de création d'ondes stationnaires entre le haut-parleur 10 et la carte électronique 3.

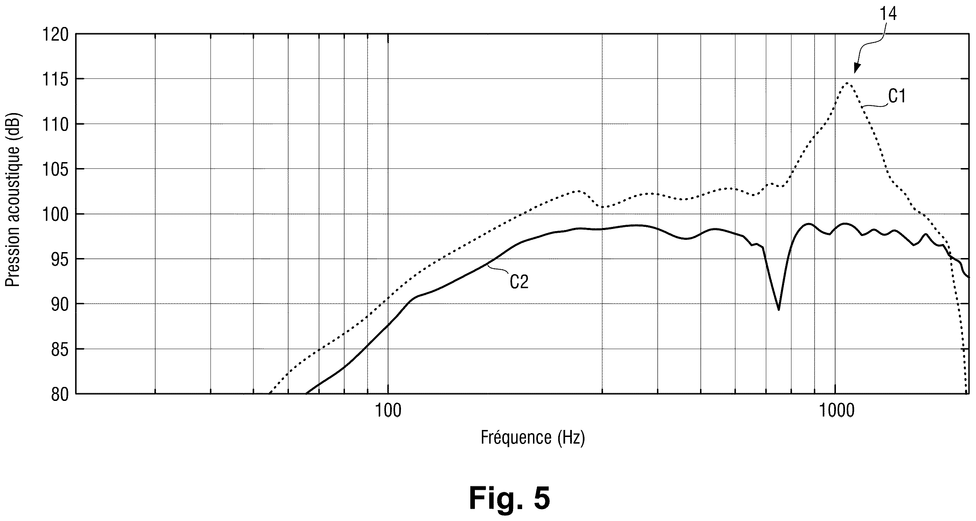

Ce phénomène est bien visible sur le graphique de la figure 5. La réponse en fréquence C1 du haut-parleur 10, alors que celui-ci est intégré dans son caisson acoustique 11 et que le caisson 11 est assemblé avec le capot supérieur 2, comporte un pic 14 marqué à environ 1 kHz. Par contre, on voit que la réponse en fréquence C2 du haut-parleur 10 ne comprend pas ce pic à 1 kHz lorsque le caisson 11 n'est pas assemblé avec le capot supérieur 2.

La configuration du haut-parleur 10 et du capot de blindage 8 qui vient d'être décrite, peut donc conduire à une diffusion du son qui n'est pas homogène et qui peut être polluée par des phénomènes de distorsions (*Total Harmonic Distortion*) et de vibrations (*Rub&Buzz*).

OBJET

L'invention a pour objet de limiter les phénomènes vibratoires parasites dans un équipement audio intégrant au moins un haut-parleur et au moins un composant électronique protégé par un capot de blindage.

RESUME

En vue de la réalisation de ce but, on propose un équipement audio comportant :

- un circuit imprimé sur lequel est monté au moins un composant électronique ;
- un haut-parleur comprenant une membrane ;
- un capot de blindage agencé pour protéger le au moins un composant électronique de perturbations électromagnétiques, le capot de blindage comportant une face externe positionnée en regard de la membrane du haut-parleur ;

la face externe comprenant au moins une surface courbe qui s'étend depuis une partie centrale de la face externe vers un contour de la face externe, le capot de blindage étant ainsi agencé pour diffracter des ondes acoustiques produites par la membrane du haut-parleur en fonctionnement de manière à réduire des vibrations indésirables du circuit imprimé et du capot de blindage.

La forme particulière du capot de blindage permet de diffuser l'énergie acoustique incidente produite par le déplacement de la membrane du haut-parleur, et donc de dissiper plus efficacement le flux d'air généré par le haut-parleur. Le capot de blindage remplit donc une double fonction. Il permet d'une part de protéger les composants électroniques de perturbations électromagnétiques, et il permet, d'autre part, de limiter, voire même de supprimer les phénomènes vibratoires parasites, et donc d'améliorer le rendu sonore de l'équipement audio. L'invention est particulièrement avantageuse dans un équipement audio compact dans lequel le haut-parleur est positionné très proche du capot de blindage.

On propose de plus un équipement audio tel que précédemment décrit, dans lequel un axe central du capot de blindage, passant par un centre de la face externe, est confondu avec un axe central du haut-parleur.

On propose de plus un équipement audio tel que précédemment décrit, dans lequel un espace libre qui s'étend entre, d'une part, la membrane et un cache-noyau du haut-parleur, et d'autre part, le capot de blindage, a une hauteur $h$ sensiblement constante.

On propose de plus un équipement audio tel que précédemment décrit, dans lequel la membrane est une membrane circulaire et dans lequel la hauteur $h$ est telle que :

$$h = \frac{D}{4},$$

où $D$ est un diamètre de la membrane.

On propose de plus un équipement audio tel que précédemment décrit, dans lequel la face externe du capot de blindage comprend :

- une surface tronconique, comprenant une concavité qui s'étend à l'intérieur de la surface tronconique ;
- un bourrelet qui s'étend au moins sur une certaine longueur du contour de la face externe ;

et dans lequel la membrane du haut-parleur s'étend en regard de la surface tronconique, un cache-noyau du haut-parleur s'étend en regard de la concavité, et une suspension du haut-parleur s'étend au moins partiellement dans un canal défini entre le bourrelet et la surface tronconique.

On propose de plus un équipement audio tel que précédemment décrit, dans lequel le bourrelet s'étend sur une partie seulement de la longueur du contour de la face externe, de sorte que ledit canal comprend deux extrémités et permet d'écouler via ces deux extrémités un flux d'air déplacé par la membrane du haut-parleur.

On propose de plus un équipement audio tel que précédemment décrit, dans lequel la face externe du capot de blindage présente, lorsqu'elle est vue en coupe selon un plan passant par l'axe central du capot de blindage, une forme parabolique au niveau du bourrelet.

On propose de plus un équipement audio tel que précédemment décrit, dans lequel le capot de blindage comprend, au niveau d'au moins une extrémité du canal, une extension qui prolonge le bourrelet et qui recouvre au moins partiellement un autre composant monté sur le circuit imprimé.

On propose de plus un équipement audio tel que précédemment décrit, dans lequel le capot de blindage est fixé à une ceinture de blindage montée sur le circuit imprimé et entourant le au moins un composant électronique, le capot de blindage comportant une face interne dans laquelle est formée une cavité interne, le capot de blindage se prolongeant de part et d'autre de la ceinture de blindage qui est positionnée dans la cavité interne.

On propose de plus un équipement audio tel que précédemment décrit, l'équipement audio étant un boîtier décodeur.

L'invention sera mieux comprise à la lumière de la description qui suit de modes de mise en œuvre particuliers non limitatifs de l'invention.

BREVE DESCRIPTION DES DESSINS

Il sera fait référence aux dessins annexés parmi lesquels :

[Fig. 1] la figure 1 représente une vue en perspective et de dessus d'un sous-ensemble d'un boîtier décodeur de l'art antérieur ;

[Fig. 2] la figure 2 représente une vue en perspective, de côté et en coupe selon un plan transversal, du sous-ensemble du boîtier décodeur ;

[Fig. 3] la figure 3 représente une vue de dessous du capot supérieur et de la carte électronique, alors que le capot de blindage n'est pas monté sur la ceinture de blindage ;

[Fig. 4] la figure 4 est une vue similaire à la figure 3, alors que le capot est monté sur la ceinture de blindage ;

[Fig. 5] la figure 5 est un graphique représentant des courbes de la réponse en fréquence du haut-parleur dans le caisson acoustique, assemblé et non assemblé avec le capot supérieur ;

[Fig. 6] la figure 6 représente une vue schématique, en coupe, d'un sous-ensemble d'un boîtier décodeur comprenant un capot supérieur, une carte électronique, un capot de blindage selon un premier mode de réalisation, et un caisson acoustique intégrant un haut-parleur ;

[Fig. 7] la figure 7 est une figure similaire à la figure 4, avec un capot de blindage selon un deuxième mode de réalisation ;

[Fig. 8] la figure 8 est une figure similaire à la figure 7, mais avec une vue de côté ;

[Fig. 9] la figure 9 est une vue en perspective et en coupe selon un plan transversal, du sous-ensemble « retourné » du boîtier décodeur ;

[Fig. 10] la figure 10 représente un résonateur de Helmholtz ;

[Fig. 11] la figure 11 est un graphique représentant des courbes de déplacement du sous-ensemble comprenant le capot supérieur et la carte électronique, avec un capot de blindage classique et avec le capot de blindage selon le deuxième mode de réalisation ;

[Fig. 12] la figure 12 est un graphique représentant des courbes de la réponse en fréquence à 10 cm en arrière du caisson acoustique, celui-ci étant intégré avec un capot de blindage classique et avec le capot de blindage selon le deuxième mode de réalisation.

## DESCRIPTION DETAILLEE

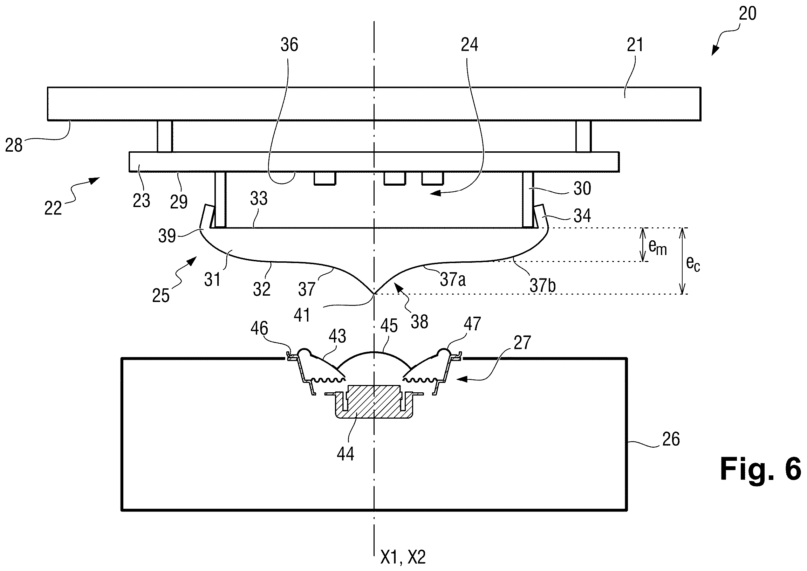

En référence à la figure 6, le boîtier décodeur 20 comporte un capot supérieur 21, une carte électronique 22 comprenant un circuit imprimé 23 et au moins un composant électronique 24 monté sur le circuit imprimé 23, un dispositif de blindage 25, et un caisson acoustique 26 intégrant un haut-parleur 27.

Le circuit imprimé 23 est fixé à une face interne 28 du capot supérieur 21 par vissage, et s'étend parallèlement à celle-ci.

Le composant électronique 24 est monté sur une face interne 29 du circuit imprimé 23.

Le dispositif de blindage 25 permet de protéger le composant électronique 24 des perturbations électromagnétiques générées par d'autres composants du boîtier décodeur 20.

Le dispositif de blindage 25 comporte une ceinture de blindage 30 et un capot de blindage 31 selon un premier mode de réalisation. La ceinture de blindage 30 est fixée au circuit imprimé 23 et s'étend autour du composant électronique 24. La ceinture de blindage 30 est en contact direct avec un plan de masse de la carte électronique 22 sur toute sa circonférence.

Le capot de blindage 31 est formé par une pièce unique en tôle pliée. Le capot de blindage 31 comprend une face externe 32, une face interne 33, et une portion périphérique 34.

La face externe 32 et la face interne 33 sont des surfaces de révolution autour d'un axe central X1 du capot de blindage 31. La portion périphérique 34, de forme cylindrique ayant pour axe l'axe central X1, s'étend depuis le contour de la face interne 33 du capot de blindage 31.

La portion périphérique 34 est insérée en force autour de la ceinture de blindage 30 pour fixer le capot de blindage 31 à la ceinture de blindage 30 et donc à la carte électronique 22. La portion périphérique 34 est alors positionnée contre la ceinture de blindage 30 et à l'extérieur de la surface 36 de la carte électronique 22 délimitée par la ceinture 30, dans laquelle est située le composant 24.

La face externe 32 du capot de blindage 31 comprend au moins une surface courbe 37 qui s'étend depuis une partie centrale 38 de la face externe 32 vers le contour 39 de la face externe 32, le capot de blindage 31 étant ainsi agencé pour diffracter des ondes acoustiques produites par le haut-parleur 27 en fonctionnement de manière à réduire des vibrations indésirables du circuit imprimé 23 et du capot de blindage 31.

Ici, la partie centrale 38 de la face externe 32 forme un pic dont le sommet est au centre 41 de la face externe 32. La face externe 32 comprend une première surface courbe 37a et une deuxième surface courbe 37b qui s'étendent successivement selon une direction radiale depuis le pic vers le contour 39 de la face externe 32. La première surface courbe 37a et la deuxième surface courbe 37b sont aussi des surfaces de révolution autour de l'axe central X1 du capot de blindage 31.

La première surface courbe 37a est une surface concave et la deuxième surface courbe 37b est une surface convexe.

Le haut-parleur 27, quant à lui, comporte classiquement une membrane 43, un noyau 44, un cache-noyau 45, un châssis 46, et une suspension 47 qui permet de fixer la membrane 43 au châssis 46. Le haut-parleur 27 est ici un haut-parleur de graves (*Woofer*). Un haut-parleur de graves est un haut-parleur qui reproduit les basses fréquences, par exemple comprises entre 100 Hz et 2 kHz. Ici, le haut-parleur 27 a une fréquence de coupure de 300 Hz.

La membrane 43 est ici une membrane circulaire.

Ici, l'axe central X1 du capot de blindage 31, passant par le centre 41 de la face externe 32, et l'axe central X2 du haut-parleur 27, sont confondus. Par « confondus », on entend qu'ils sont réellement confondus, ou bien que la distance qui les sépare est très faible.

On a ainsi, avantageusement :

$$d < \frac{D}{20},$$

où *d* est la distance entre les deux axes centraux X1, X2 et *D* est le diamètre de la membrane 43.

La face interne 33 du capot de blindage 31 est une surface plane. Le capot de blindage 31 est épaissi, c'est-à-dire que l'épaisseur *e* du capot de blindage 31, qui est donc la dimension selon un axe parallèle à l'axe X1 entre la face externe 32 et la face interne 33, est supérieure à celle d'un capot traditionnel en tôle.

Ici, l'épaisseur $e_c$ du capot 31 au niveau du centre 41 du capot 31 est telle que :

$$e_c > 2 \times e_m,$$

où $e_m$ est l'épaisseur minimale du capot 31.

Cette forme particulière du capot de blindage 31, ainsi que la position centrée du capot de blindage 31 par rapport au haut-parleur 27, ont pour effets de favoriser la diffraction puis la diffusion de l'onde sonore incidente, et donc de réduire l'énergie vibratoire transmise à la carte électronique 22. Cette forme et cette position permettent également de limiter, voire de supprimer la formation d'ondes stationnaires en évitant les plans parallèles. Par ailleurs, l'épaississement du capot de blindage 31 permet de rigidifier le capot de blindage 31 afin de prévenir de tout risque de vibrations contre la ceinture de blindage 30.

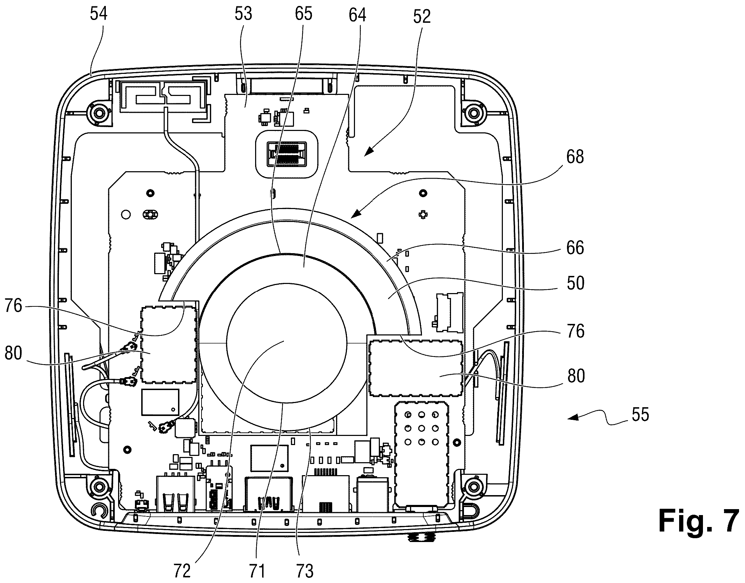

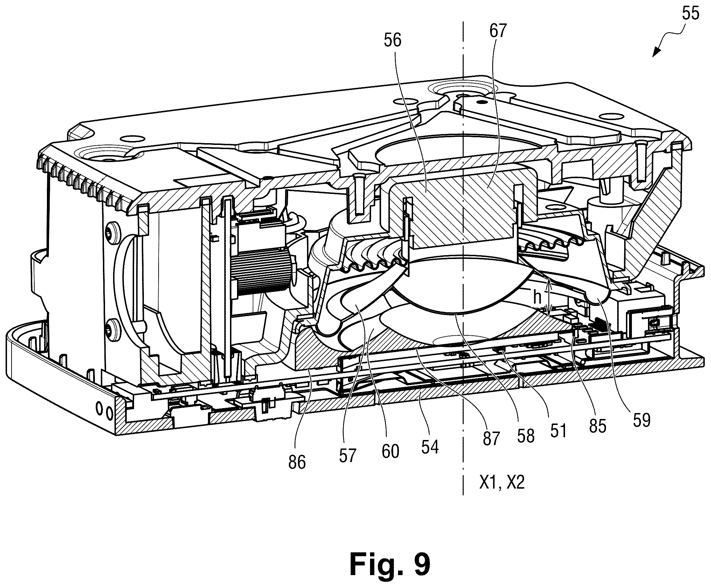

On décrit maintenant, en référence aux figures 7 à 9, un capot de blindage 50 selon un deuxième mode de réalisation.

A nouveau, le capot de blindage 50 vise à protéger un ou des composants électroniques 51 d'une carte électronique 52 dont le circuit imprimé 53 est fixé au capot supérieur 54 du boîtier décodeur 55.

La forme du capot de blindage 50 est cette fois différente et adaptée à un espace disponible très réduit.

Le haut-parleur 56, qui est à nouveau un haut-parleur de graves, comprend une membrane 57, un noyau 67, un cache-noyau 58 et une suspension 59.

Un espace libre 60, qui s'étend entre, d'une part, la membrane 57 et le cache-noyau 58, et d'autre part, le capot de blindage 50, a une hauteur *h* sensiblement constante. Cette hauteur *h* est ici définie selon une dimension parallèle à l'axe central X1 du capot de blindage 50 et à l'axe central X2 du haut-parleur 56, qui sont confondus.

Par « sensiblement constante », on considère ici que cette hauteur *h* est constante à $\pm$ 10%.

Cet espace libre 60 forme un passage pour l'air.

Le profil de la surface externe du haut-parleur 56 en regard de ce passage 60, est identique au profil de la face externe 61 du capot de blindage 50 en regard dudit passage 60.

La forme du capot 50 suit donc le profil de la membrane 57 du haut-parleur 56, ce qui permet de maximiser la surface non-plane en regard du haut-parleur 56, tout en tenant compte du débattement maximum de sa membrane 57.

La face externe 61 du capot de blindage 50 comporte :

- une surface tronconique 64 et une concavité 65 qui s'étend à l'intérieur de la surface tronconique 64 ;
- un bourrelet 66 qui s'étend au moins sur une certaine longueur du contour 68 de la face externe 61.

La surface tronconique 64 et la concavité 65 sont des surfaces de révolution autour de l'axe central X1 du capot de blindage 50.

La membrane 57 du haut-parleur 56 s'étend en regard de la surface tronconique 64, le cache-noyau 58 du haut-parleur 56 s'étend en regard de la concavité 65, et la suspension 59 du haut-parleur 56 s'étend au moins partiellement dans un canal 70 défini entre le bourrelet 66 et la surface tronconique 64.

La surface tronconique 64 a une première extrémité 71 (qui délimite la concavité 65), ici circulaire, située du côté du centre 72 de la face externe 61, et une deuxième extrémité 73, aussi circulaire, située du côté du contour 68 de la face externe 61. Le diamètre de la deuxième extrémité 73 est supérieur à celui de la première extrémité 71, et la surface tronconique 64 s'évase donc depuis sa première extrémité 71 en formant une pente qui s'étend jusqu'à la deuxième extrémité 73 et jusqu'au bas du bourrelet 66. La surface tronconique 64 a une forme sensiblement complémentaire de celle de la membrane 57 du haut-parleur 56.

La concavité 65 forme une surface courbe qui s'étend depuis une partie centrale 63 de la face externe 61 (ici depuis le centre 72 de la face externe 61) vers le contour 68 de la face externe 61. Le centre 72 de la face externe 61, par lequel passe l'axe X1, est aussi le point le plus profond de la concavité 65.

La concavité 65 a ici un profil parabolique ou circulaire et présente une forme sensiblement complémentaire de celle du cache-noyau 58 du haut-parleur 56.

La face externe 61 du capot 50 présente, lorsqu'elle est vue en coupe selon un plan passant par l'axe central X1 du capot, une forme parabolique au niveau du bourrelet 66.

Ainsi, lorsque le boîtier décodeur 55 est assemblé, la membrane 57 s'étend en regard de la surface tronconique 64 et parallèlement à celle-ci, et le cache-noyau 58 s'étend en regard de la concavité 65. Lorsque le haut-parleur 56 fonctionne, la membrane 57 vibre et se déplace, de sorte que la membrane 57 et le cache-noyau 58 se rapprochent et s'éloignent de la face externe 61 du capot de blindage 50. Le cache-noyau 58 pénètre partiellement dans la concavité 65. La surface tronconique 64 et la concavité 65 sont dimensionnées de sorte que la membrane 57 et le cache-noyau 58 ne viennent pas en contact avec le capot de blindage 50.

La forme du capot de blindage 50 permet donc d'optimiser l'intégration du haut-parleur 56 et du capot de blindage 50, ce qui est extrêmement avantageux lorsque l'encombrement très réduit ne permet pas d'intégrer un capot de blindage tel que le capot 8 selon le premier mode de réalisation.

Le déplacement de la membrane 57 génère un flux d'air.

Avantageusement, pour éviter les perturbations acoustiques et les surpressions devant le haut-parleur 56, la vitesse d'écoulement de l'air en sortie du boîtier décodeur 55 doit être la plus proche possible de la vitesse de déplacement de la membrane 57 du haut-parleur 56. Pour cela, il faut que la multiplication de la hauteur *h* de l'espace libre 60 au-dessus de la membrane 57 par son périmètre *P* soit égale à sa surface *S* :

$$h * P = S,$$

soit dans le cas particulier d'une membrane circulaire de diamètre *D* :

$$h = \frac{D}{4}.$$

On voit que le bourrelet 66 s'étend sur une partie seulement de la longueur du contour 68 de la face externe 61 du capot de blindage 50, de sorte que le canal 70 comprend deux extrémités 76 et forme un canal d'évacuation d'air ayant pour sorties lesdites extrémités 76, qui permet d'écouler via ces deux extrémités un flux d'air 77 déplacé par la membrane 57 du haut-parleur 56. L'écoulement de l'air est donc réalisé selon des directions parallèles à des tangentes, au niveau des extrémités 76, au cercle formé par la deuxième extrémité 73 de la surface tronconique 64.

Le canal d'évacuation d'air 70 permet d'évacuer l'air latéralement vers l'extérieur du boîtier décodeur 55, ici via des orifices prévus à cet effet dans une partie inférieure du capot supérieur 54 qui forme une partie supérieure de la face arrière 79 du boîtier décodeur 55.

Ici, on voit que deux autres dispositifs de blindage sont montés sur le circuit imprimé 53, avec des capots de blindage 80 « traditionnels ». Ces capots de blindage 80 sont positionnés de sorte que le canal d'évacuation d'air 70 débouche, au niveau de chacune de ses extrémités 76, sur l'un des capots de blindage 80.

On note que le bourrelet 66 pourrait être étendu pour s'étendre sur les capots de blindage 80, ce qui permettrait d'obtenir une surface sans ou avec peu de discontinuité et donc de favoriser l'écoulement d'air.

Le capot de blindage 50 peut donc comprendre, au niveau d'au moins une extrémité du canal 70, une extension 81 qui prolonge le bourrelet 66 et qui recouvre au moins partiellement un autre composant monté sur le circuit imprimé 53.

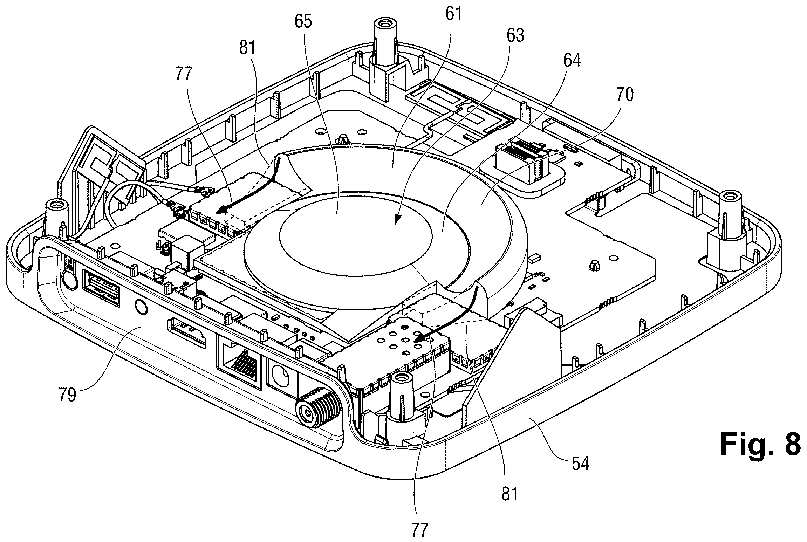

Le capot de blindage 50 peut comprendre deux extensions 81, c'est-à-dire une extension 81 au niveau de chaque extrémité du canal 70. Celles-ci sont représentées schématiquement, en pointillés, sur la figure 8.

Chaque extension 81 s'étend alors selon la direction du flux d'air 77 et recouvre au moins partiellement l'un des capots de blindage 80.

Avantageusement, chaque extension 81 du bourrelet 66 présente une forme parabolique lorsqu'elle est vue dans un plan par lequel passe la direction du flux d'air 77 en sortie du canal 70.

Avantageusement, au moins l'une des extrémités 76 du canal 70, ou au moins l'une des extensions 81, débouche sur la carte électronique 52 au niveau d'une surface sur laquelle est monté au moins un composant dont le fonctionnement nécessite un refroidissement. Ce composant est par exemple un composant audio qui est activé lorsque le haut-parleur 56 fonctionne. Le flux d'air généré par le haut-parleur 56 et circulant dans le canal 70 permet ainsi de refroidir ce composant.

Le capot de blindage 50 remplit alors trois fonctions : blindage électromagnétique ; déflecteur acoustique ; refroidissement.

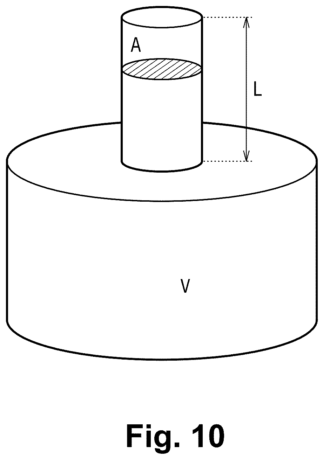

En référence à la figure 10, une analogie avec un modèle simple permet d'assimiler à un résonateur de Helmholtz la cavité entre le haut-parleur 56 et les sorties de son du boîtier décodeur 55 :

$$f_{Helmholtz} = \frac{c}{2\pi}\sqrt{\frac{A}{VL}}$$

où $c$ est la célérité du son dans l'air ($c = 340$ m.s$^{-1}$), $A$ est la section du col, $L$ sa longueur, et $V$ le volume de la cavité.

L'utilisation du capot de blindage 50 « déflecteur » permet de réduire le volume $V$ de la cavité. L'utilisation des extensions 81 avec un profil parabolique permet de ne pas diminuer la dimension de la section.

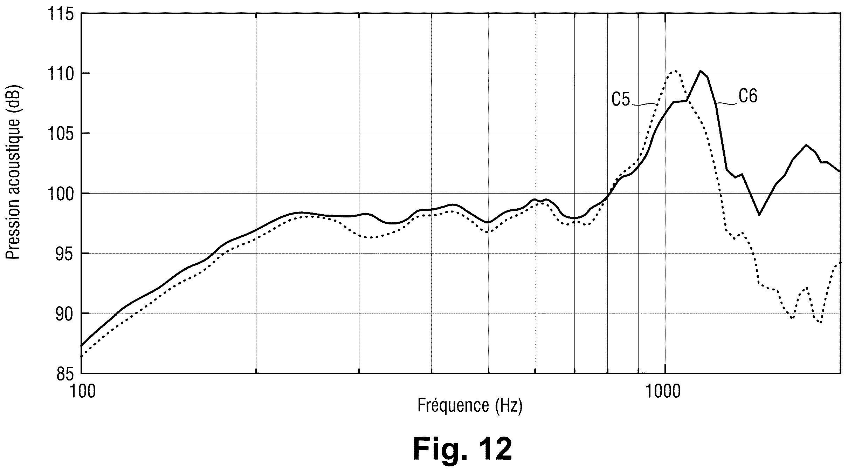

Ainsi, en réduisant le volume V, le capot de blindage 50 déflecteur a pour effet d'augmenter la fréquence de résonance acoustique associée de sorte qu'elle soit en dehors de la bande passante du haut-parleur (e.g. woofer). Cet avantage du capot de blindage 50 déflecteur est décrit ci-après selon l'exemple de la figure 12.

On constate aussi que le profil particulier du capot de blindage 50 permet de rigidifier plus efficacement le capot de blindage 50 en décalant l'ajout de matière, donc de masse, du centre de la tôle pour la répartir sur le pourtour du capot de blindage 50 et donc au niveau du bourrelet 66.

Ici, en outre, afin de limiter au maximum la présence de plans parallèles et augmenter l'efficacité de la diffusion et de la diffraction du son, le capot de blindage 50 se prolonge de part et d'autre de la ceinture de blindage 85.

On a ici :

$$d1 > 1,3.d2,$$

où $d1$ est le diamètre du capot de blindage 50 et $d2$ est le diamètre de la ceinture de blindage 85.

Le capot 50 comprend une face interne 86.

Une cavité interne 87 est formée dans la face interne 86. La cavité interne 87 est positionnée au centre de la face interne 86 et est de forme cylindrique et de diamètre sensiblement égal à celui de la ceinture de blindage 85 (très légèrement supérieur). Lorsque le capot de blindage 50 est fixé à la ceinture de blindage 85, celle-ci est positionnée dans la cavité interne 87 et la surface latérale de la cavité interne 87 est appliquée contre la surface externe de la ceinture de blindage 85.

De manière générale, le diamètre $d1$ du capot de blindage 50 est déterminé en fonction du volume disponible dans la cavité interne 87, ce volume étant défini en fonction du diamètre de la cavité interne.

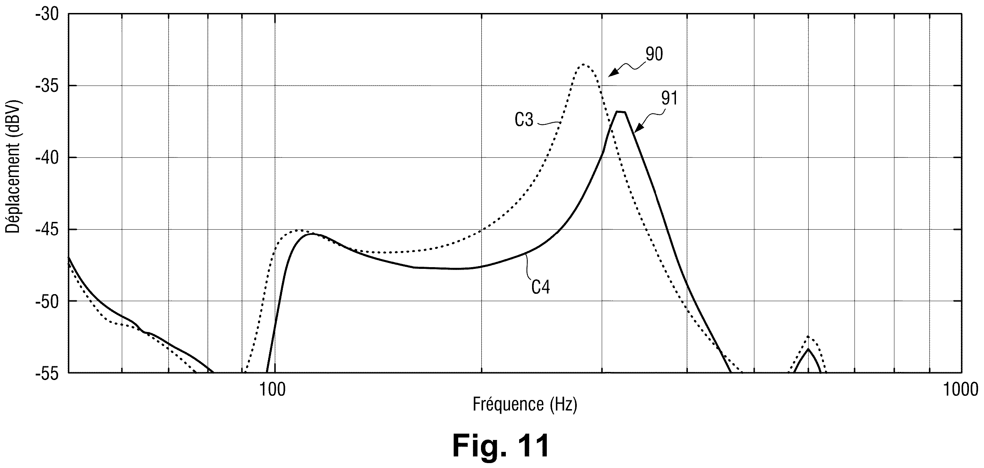

En référence à la figure 11, on a réalisé des mesures du déplacement d'un sous-ensemble comprenant le capot supérieur 50 et la carte électronique 52, au moyen d'un dispositif de mesure laser, lorsque le haut-parleur 56 est en fonctionnement.

On observe que, avec un capot de blindage classique (sans effet déflecteur), la réponse en fréquence C3 comprend un pic de résonnance 90 correspondant au déplacement maximal du capot supérieur. Avec le capot de blindage 50, on constate que l'amplitude du pic de résonance 91 de la réponse en fréquence C4 a diminué de 30%, et donc que le déplacement maximal du capot supérieur 54 a lui aussi diminué de 30%. On note aussi une augmentation de la fréquence de résonance du pic de 12%.

Cette augmentation de la fréquence de résonance, et donc de la fréquence du maximum de déplacement mesuré, est très intéressante. En effet, si on la rend supérieure à la fréquence de coupure du haut-parleur 56 (e.g. 300 Hz dans le cas du boîtier décodeur 55), elle ne peut pas être atteinte et donc le boîtier décodeur 55 ne va pas subir les effets de cette résonance.

En référence à la figure 12, on a aussi mesuré la réponse en fréquence C5 du haut-parleur 56 à 10cm, face à l'arrière du caisson acoustique, avec un capot traditionnel, et la réponse en fréquence C6 avec le capot de blindage 50.

On voit que la réduction du volume de la cavité conduit à une augmentation de la fréquence du pic de résonance. Par ailleurs, le niveau global de la courbe C6 est plus élevé, ce qui montre que la quantité d'énergie rayonnée par l'arrière est plus importante. En outre, la réponse en fréquence mesurée avec le capot de blindage 50 est plus homogène et plate (e.g. +/-2dB dans la bande de fréquences passante du haut-parleur).

Bien entendu, l'invention n'est pas limitée aux modes de réalisation décrits mais englobe toute variante entrant dans le champ de l'invention tel que défini par les revendications.

L'équipement électrique dans lequel est mise en œuvre l'invention n'est pas nécessairement un boîtier décodeur. L'invention s'applique à tout équipement audio (c'est-à-dire à tout équipement capable de restituer un signal sonore) comprenant au moins un haut-parleur, des composants électroniques et un capot de blindage : enceinte connectée, téléviseur, etc.

Le dispositif de blindage, comportant le capot de blindage, ne comprend pas nécessairement une ceinture de blindage. Le capot de blindage pourrait être fixé à la carte électronique (et relié au plan de masse) de manière différente.

Le haut-parleur n'est pas nécessairement un haut-parleur de graves.

La membrane du haut-parleur n'a pas nécessairement une membrane circulaire, elle pourrait être à section carrée ou rectangulaire.

## Revendications

**1.** Equipement audio (20 ; 55) comportant :

- un circuit imprimé (23 ; 53) sur lequel est monté au moins un composant électronique (24 ; 51) ;
- un haut-parleur (27 ; 56) comprenant une membrane (43 ; 57) ;
- un capot de blindage (31 ; 50) agencé pour protéger le au moins un composant électronique de perturbations électromagnétiques, le capot de blindage comportant une face externe (32 ; 61) positionnée en regard de la membrane (43 ; 57) du haut-parleur (27 ; 56) ;

la face externe (32 ; 61) comprenant au moins une surface courbe (37 ; 65) qui s'étend depuis une partie centrale (38 ; 63) de la face externe (32 ; 61) vers un contour (39 ; 68) de la face externe, le capot de blindage (31 ; 50) étant ainsi agencé pour diffracter des ondes acoustiques produites par la membrane du haut-parleur en fonctionnement de manière à réduire des vibrations indésirables du circuit imprimé (23 ; 53) et du capot de blindage (31 ; 50).

**2.** Equipement audio selon la revendication 1, dans lequel un axe central (X1) du capot de blindage (31 ; 50), passant par un centre (41 ; 72) de la face externe (32 ; 61), est confondu avec un axe central (X2) du haut-parleur (27 ; 56).

**3.** Equipement audio selon la revendication 2, dans lequel un espace libre (60) qui s'étend entre, d'une part, la membrane (57) et un cache-noyau (58) du haut-parleur (56), et d'autre part, le capot de blindage (50), a une hauteur *h* sensiblement constante.

**4.** Equipement audio selon la revendication 3, dans lequel la membrane (57) est une membrane circulaire et dans lequel la hauteur *h* est telle que :

$$h = \frac{D}{4},$$

où *D* est un diamètre de la membrane (57).

**5.** Equipement audio selon la revendication 3 ou 4, dans lequel la face externe (61) du capot de blindage (50) comprend :

- une surface tronconique (64), comprenant une concavité (65) qui s'étend à l'intérieur de la surface tronconique (64) ;
- un bourrelet (66) qui s'étend au moins sur une certaine longueur du contour (68) de la face externe (61) ;

et dans lequel la membrane (57) du haut-parleur (56) s'étend en regard de la surface tronconique, un cache-noyau (58) du haut-parleur s'étend en regard de la concavité (65), et une suspension (59) du haut-parleur s'étend au moins partiellement dans un canal (70) défini entre le bourrelet et la surface tronconique.

6. Equipement audio selon la revendication 5, dans lequel le bourrelet (66) s'étend sur une partie seulement de la longueur du contour (68) de la face externe (61), de sorte que ledit canal (70) comprend deux extrémités (76) et permet d'écouler via ces deux extrémités un flux d'air (77) déplacé par la membrane du haut-parleur.

7. Equipement audio selon la revendication 5 ou 6, dans lequel la face externe (61) du capot de blindage présente, lorsqu'elle est vue en coupe selon un plan passant par l'axe central (X1) du capot de blindage, une forme parabolique au niveau du bourrelet (66).

8. Equipement audio selon la revendication 6 ou 7, dans lequel le capot de blindage (50) comprend, au niveau d'au moins une extrémité du canal (70), une extension (81) qui prolonge le bourrelet (66) et qui recouvre au moins partiellement un autre composant (80) monté sur le circuit imprimé (53).

9. Equipement audio selon l'une des revendications précédentes, dans lequel le capot de blindage est fixé à une ceinture de blindage (85) montée sur le circuit imprimé (53) et entourant le au moins un composant électronique (51), le capot de blindage (50) comportant une face interne (86) dans laquelle est formée une cavité interne (87), le capot de blindage (50) se prolongeant de part et d'autre de la ceinture de blindage (85) qui est positionnée dans la cavité interne (87).

10. Equipement audio selon l'une des revendications précédentes, l'équipement audio étant un boîtier décodeur (20 ; 55).

**Fig. 1**

Fig. 2

**Fig. 3**

**Fig. 4**

EP 4 761 279 A1

**Fig. 5**

EP 4 761 279 A1

Fig. 6

Fig. 7

Fig. 8

Fig. 9

**Fig. 10**

Fig. 11

**Fig. 12**

RAPPORT DE RECHERCHE EUROPEENNE

Numéro de la demande

EP 25 22 3067

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | FR 3 125 912 A1 (SAGEMCOM BROADBAND SAS [FR]) 3 février 2023 (2023-02-03) * alinéas [0021] - [0025], [0065], [0110] - [0113]; figures 1,3,4 * ----- | 1-10 | INV. H04R1/34 H04R1/02 H04R1/30 |
| A | FR 3 139 405 A1 (SAGEMCOM BROADBAND SAS [FR]) 8 mars 2024 (2024-03-08) * alinéas [0034], [0095] - [0098], [0109], [0110], [0131]; figures 1,3,4,5,7,8 * ----- | 1-10 | |
| A | US 2016/227315 A1 (KIM WONTAK [US] ET AL) 4 août 2016 (2016-08-04) * alinéas [0002], [0022] - [0023], [0035]; figures 1-3 * ----- | 1 | |
| A | US 2020/227015 A1 (LITOVSKY ROMAN N [US] ET AL) 16 juillet 2020 (2020-07-16) * alinéas [0044] - [0052]; figures 6-8 * ----- | 1 | |

**DOMAINES TECHNIQUES RECHERCHES (IPC)**

H04R

Le présent rapport a été établi pour toutes les revendications

| Lieu de la recherche | Date d'achèvement de la recherche | Examinateur |
|---|---|---|
| La Haye | 16 avril 2026 | Bensa, Julien |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**  EP 25 22 3067

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

16-04-2026

| Document brevet cité au rapport de recherche | | | Date de publication | Membre(s) de la famille de brevet(s) | | | Date de publication |
|---|---|---|---|---|---|---|---|
| FR 3125912 | A1 | | 03-02-2023 | AUCUN | | | |
| FR 3139405 | A1 | | 08-03-2024 | CN | 118158600 | A | 07-06-2024 |
| | | | | EP | 4383748 | A1 | 12-06-2024 |
| | | | | FR | 3139405 | A1 | 08-03-2024 |
| | | | | IL | 308995 | A | 01-07-2024 |
| | | | | US | 2024188235 | A1 | 06-06-2024 |
| US 2016227315 | A1 | | 04-08-2016 | CN | 107431854 | A | 01-12-2017 |
| | | | | EP | 3251378 | A1 | 06-12-2017 |
| | | | | JP | 6553732 | B2 | 31-07-2019 |
| | | | | JP | 2018504056 | A | 08-02-2018 |
| | | | | US | 2016227315 | A1 | 04-08-2016 |
| | | | | US | 2017085983 | A1 | 23-03-2017 |
| | | | | WO | 2016123428 | A1 | 04-08-2016 |
| US 2020227015 | A1 | | 16-07-2020 | US | 2020227015 | A1 | 16-07-2020 |
| | | | | WO | 2020150190 | A1 | 23-07-2020 |

EPO FORM P0460

Pour tout renseignement concernant cette annexe : voir Journal Officiel de l'Office européen des brevets, No.12/82